# EUROPEAN PATENT SPECIFICATION

(11) **EP 1 974 400 B1**
(45) Date of publication and mention of the grant of the patent: **13.03.2013**
(21) Application number: 07700370.5
(22) Date of filing: 12.01.2007
(51) Int. Cl.: H01L 51/00, H01L 51/05

(54) **METHOD OF FABRICATING A SEMICONDUCTOR DEVICE**
VERFAHREN ZUR HERSTELLUNG EINER HALBLEITERANORDNUNG
PROCÉDÉ DE FABRICATION D UN DISPOSITIF SEMI-CONDUCTEUR

(30) Priority: 18.01.2006 GB 0601008
(43) Date of publication of application: 01.10.2008
(73) Proprietor: QinetiQ Limited, Farnborough Hampshire GU14 0LX (GB)
(72) Inventor: ROSE, Paul, James, Malvern, Worcestershire, WR14 3PS (GB); SAGE, Ian, Charles, Malvern WR14 3PS (GB); TUFFIN, Rachel, Patricia, Malvern WorcsWR14 3PS (GB)
(74) Representative: Humphreys, Elizabeth Jane
(86) International application number: PCT/GB2007/000080
(87) International publication number: WO 2007/083087

(56) References cited:
- US-A1- 2004 262 599
- US-A1- 2005 186 699
- US-B1- 6 635 406
- GUO TZUNG-FANG ET AL: "Vertically integrated electronic circuits via a combination of self-assembled polyelectrolytes, ink-jet printing, and electroless metal plating processes" LANGMUIR; LANGMUIR OCT 15 2002, vol. 18, no. 21, 15 October 2002 (2002-10-15), pages 8142-8147, XP008076097
- MENARD E ET AL: "Bendable single crystal silicon thin film transistors formed by printing on plastic substrates" APPLIED PHYSICS LETTERS, AIP, AMERICAN INSTITUTE OF PHYSICS, MELVILLE, NY, US, vol. 86, no. 9, 25 February 2005 (2005-02-25), pages 93507-93507, XP012066562 ISSN: 0003-6951
- HUR SEUNG-HYUN ET AL: "Extreme bendability of single-walled carbon nanotube networks transferred from high-temperature growth substrates to plastic and their use in thin-film transistors" APPLIED PHYSICS LETTERS, AIP, AMERICAN INSTITUTE OF PHYSICS, MELVILLE, NY, US, vol. 86, no. 24, 7 June 2005 (2005-06-07), pages 243502-243502, XP012065891 ISSN: 0003-6951
- NG W K ET AL: "Microcontact printing of catalytic nanoparticles for selective electroless deposition of metals on nonplanar polymeric substrates" APPLIED PHYSICS LETTERS, AIP, AMERICAN INSTITUTE OF PHYSICS, MELVILLE, NY, US, vol. 81, no. 16, 14 October 2002 (2002-10-14), pages 3097-3099, XP012032235 ISSN: 0003-6951
- XIA Y ET AL: "SOFT LITHOGRAPHY" ANGEWANDTE CHEMIE. INTERNATIONAL EDITION, WILEY VCH VERLAG, WEINHEIM, DE, vol. 37, 1998, pages 551-575, XP000985399 ISSN: 1433-7851

## Description

The present invention relates to a method of fabricating a semiconductor device and in particular to a method of fabricating a thin film transistor (TFT) device. The invention relates specifically, but not exclusively, to a. method of fabricating an organic thin film transistor for a display device.

Organic thin film transistors (TFTs) are of interest for a variety of low-cost, large area electronic applications, such as active-matrix displays, chemical sensors, and flexible micro electronics.

By way of background to the present invention, a TFT device typically comprises two conducting electrodes (source and drain) which make contact with a semiconductor layer. A third electrode (the gate) is adjacent to but insulated from the semiconductor layer. In operation, the current passing from source to drain electrodes is controlled by a voltage applied to the gate. It is desirable for the source-drain distance to be small (commonly 0.1-10*µ*m) and the insulation between the gate and the semiconductor channel to be thin (10nm-1*µ*m) in order to achieve high performance.

TFT devices are commonly manufactured by traditional semiconductor processing routes including high vacuum deposition, and photolithography. However, such conventional deposition and patterning processes are expensive. Particularly in the context of low-cost, large-volume manufacturing, there is an ongoing requirement to develop inexpensive material deposition and patterning processes which may be combined with existing device concepts to provide organic TFT devices and integrated circuits having acceptable performance.

Mindful of the foregoing requirement, high resolution printing techniques have been suggested as an alternative, inexpensive route to manufacturing TFT devices.

By way of example, organic TFTs have been demonstrated with gate electrodes and source and drain contacts prepared by screen printing of conducting graphite-based inks (see Gamier, F. et al., Science 1994, 265, 1684). Similarly, it is known to use screen printing to deposit the gate dielectric layer in an organic TFT (see Bao, Z. et al., Polym. Mater. Sci. Eng. 1997, 77, 409).

Alternatively, inkjet printing has been used for the deposition of a conductive polymer to define the source and drain contacts and the gate electrodes of organic TFTs on glass substrates (Sirringhaus, H. et al., Science 2000, 290, 2123).

However, while screen printing and inkjet printing have been successfully utilised to make organic TFTs, the minimum feature resolution attainable by these methods is several tens of micrometer at best, which is insufficient for many practical applications.

Features having smaller dimensions can however be achieved with screen printing and inkjet printing by selectively modifying the surface energy of the layer upon which the ink is printed. The technique involves providing a surface with patterned surface energy, and printing a water-based dispersion of conductive material onto said surface. The water based ink de-wets from defined areas of the treated surface, for example forming an insulating gap which can be used to accurately define the source/drain path in a TFT. This process is workable but relies on pre-treatment of the surface by complex processes such as photolithography in order to provide the modulated surface energy.

Alternative printing techniques do however exist which are theoretically capable of producing features at micrometer resolution, including micromolding in capillaries (MIMIC) and micro-contact printing (*µ*CP).

Micro-contact printing is a soft lithography technique based on rubber stamping and can define features on a scale well below 1*µ*m. In a typical process for making a TFT, a thiol compound is printed by soft lithography onto a gold metal surface and binds to it. The areas of gold which are not protected by the thiol are then etched away to define source and drain electrodes. Although effective, this method relies on costly vacuum deposition of the gold, and an etching process which is difficult to control, slow, and environmentally undesirable.

In an alternative soft lithographic process, micro-contact printing has been used to print a palladium seed layer to selectively initiate electroless plating of metal, thereby facilitating the creation of metallization in the seeded areas of substrates. The process is beneficial in that it is an entirely additive process, i.e. no etching is required to pattern the metal. However, this technique is potentially incompatible with existing TFT designs and fabrication techniques. The palladium catalyst must be deposited at a significantly high density to initiate growth of a high quality metal layer. Micro-contact printing by contrast is best suited to deposit very low concentrations of material on a surface, for example, to deposit a molecular monolayer onto a surface. Attempts to print heavy deposits of material adversely affect the resolution which can be achieved. Conversely, micro-contact printing of a light deposit of catalyst tends to provide incomplete, slow or very rough growth of metal in subsequent electroless plating, all of which are undesirable.

A further soft lithographic process has been used to deposit metal tracks on glass or silicon surface, but not to fabricate TFT structures. In this process a phosphinophosphonic acid is printed onto the surface by contact lithography. Subsequent treatment of the surface with a palladium electroless catalyst dispersion results in the catalyst binding selectively to the printed areas, and later immersion of the treated substrate in an electroless copper or nickel plating bath results in selective plating of metal onto the printed areas. The technique suffers from drawbacks which have hitherto been unrecognised, and which make it unsuitable for application to the fabrication of printed TFTs.

Firstly, many of the polymer materials routinely used in organic TFTs have a high affinity for palladium which causes unwanted binding of the palladium to the polymer material. This in turn can create short-circuits within the TFT which degrade or destroy the performance of the device. Secondly, the use of an electroless plating procedure to deposit the metallization onto the palladium seed layer can unexpectedly degrade the gate insulator due to leaching of metallic salts from the plating solution into the insulator material. This is particularly evident where the gate insulator material comprises certain conventional polymer materials. Finally, the chemical solutions used in the electroless plating procedure can cause unwanted erosion or destruction of conventional polymer gate insulator materials due to their acidic, alkaline or reducing nature.

Notwithstanding the foregoing, although soft lithography is theoretically capable of defining features on a scale well below 1*µ*m, it has hitherto been thought impractical to use micro-contact printing in large-volume manufacturing to obtain features smaller than 5*µ*m because of the perceived dimensional instability of conventional substrate materials.

US 2005/0186699 teaches electroless deposition of metal electrodes in organic TFTs.

It is an object of the invention to provide an alternative method of fabricating a semiconductor device, in particular but not exclusively a thin film transistor, which mitigates at least some of the disadvantages of the methods described above.

According to a first aspect of the present invention there is now proposed a method of fabricating an electrode structure for a multilayer semiconductor device comprising a semiconductor layer having a first electrode layer in contact therewith and a second electrode layer separated there-from by a dielectric layer, the method comprising the steps of;
(i) applying a patterning material only to selected areas of a support layer within the device so as to define the arrangement of the first electrode layer thereon,
(ii) applying to the support layer a catalyst adapted to be responsive to the patterning material,
(iii) applying a conductive material to the support layer so as to form the first electrode layer thereon, the step of applying the conductive material to the support layer comprising electroless deposition,
wherein the support layer, the patterning material and the catalyst cooperate such that the conductive material is only deposited on the selected areas of the support layer to which the catalyst has been applied,
characterised in that the support layer comprises an epoxide compound.

The catalyst may be adapted to respond to the patterning material by preferentially attaching thereto (i.e. the catalyst has a high chemical affinity for the patterning material). Alternatively, the catalyst may be adapted to respond to the patterning material by preferentially detaching there-from (i.e. the catalyst has a low chemical affinity for the patterning material).

The method provides unique advantages for fabrication of semiconductor device structures. The soft lithographic patterning can provide resolution at sub-micron levels, and the electrode structure can be deposited at high resolution without costly vacuum or high temperature processing. Moreover the process can be carried out in a substantially additive manner without the need for photolithographic exposure and etch of the substrate and its attendant structures. Less waste is produced and less energy required, adding to the cost effectiveness of the process. The process avoids deficiencies inherent in the processes of the prior art by avoiding electrode deposition in areas where it is not required, avoiding short circuit defects. Moreover erosion of the dielectric layer is avoided, preventing high leakage currents in the devices. The use of soft lithography means that devices can be fabricated on flexible and curved surfaces, which has hitherto been difficult.

In a preferred embodiment, the support layer comprises the dielectric layer. In this embodiment, the method may comprise an initial step of forming the second electrode layer and applying a dielectric material thereto so as to form the dielectric layer thereon.

In this embodiment, the conductive material is preferably deposited on the dielectric layer so as to form a first and a second metallic electrode thereon, and the method advantageously comprises the further step of;
(iv) forming the semiconductor layer by applying a semiconductor material to at least part of the dielectric layer so as to make electrical contact with the first and second metallic electrodes.

In an alternative embodiment, the support layer comprises a substrate layer. In this alternative embodiment, the conductive material is preferably deposited on the substrate layer so as to form a first and a second metallic electrode thereon, and the method conveniently comprises the further steps of;
(iv) forming the semiconductor layer by applying a semiconductor material to at least part of the substrate layer so as to make electrical contact with the first and second metallic electrodes;
(v) applying a dielectric material to the semiconductor layer so as to form the dielectric layer thereon,
(vi) forming the second electrode layer by applying a substantially conductive electrode to the dielectric layer.

The second electrode layer may comprise common metals such as Ag, Al, Au, Cu, Ni, Pd, Pt, Ti, conducting oxides such as indium oxide, tin oxide, indium tin oxide, zinc oxide, conducting polymers including poly(aniline) and poly(dioxanylthiophene) (PEDOT) having a sheet conductivity of at least 10⁻⁶ Siemens.

Advantageouslly, the semiconductor device is configured as a thin film transistor in which the second electrode layer forms a substantially conductive gate electrode and the first and second metallic electrodes form the source and drain respectively.

The use of an epoxide material for the support layer is beneficial since epoxide based materials have been found to possess an excellent combination of physical, chemical and electronic properties which include; excellent dielectric properties, surface functionality to bind the patterning material, they do not bind the catalyst, easy to apply, environmentally stable and mechanically robust, low cost, adaptable to a wide range of processes, for example by ultraviolet or thermal curing, and easy to achieve high quality, smooth, pinhole-free films. Furthermore, the epoxide based materials are compatible with the processing steps subsequently used in the present method (in particular deposition of plated metal by an electroless deposition process); namely they provide excellent adhesion of the conductive material comprising the first electrode layer (plated metal electrodes), they are not eroded by an electroless plating bath, and they are not doped by metal ions in an electroless plating bath.

The dielectric material may comprise at least one of an epoxide monomer and an epoxide co-polymer.

Conveniently, the dielectric material includes a reagent adapted to polymerise the dielectric material. The reagent may include at least one of triphenylsulphonium salts, boron trifluoride-amine adducts, polyfunctional amines, carboxylic acid anhydrides, and polyfunctional thiols.

Where the dielectric material includes a reagent adapted to polymerise the dielectric material, the method preferably includes the additional step of polymerising the dielectric material.

Advantageously, the dielectric material comprises an epoxide compound having a degree of functionality in the range 1 - 12. The degree of functionality of the compound relates to the number of reactive groups in each molecule as will be readily understood by the skilled practitioner. For example, the dielectric material may comprise at least one of SU8 epoxy resin, alkyl and cycloalkyl glycidyl ethers having an alkyl chain length from 1 to 20, aryl glycidyl ethers, ethylene glycol bis glycidyl ether, propylene glycol bis glycidyl ether, trimethylolpropane triglycidyl ether, esters of glycidol, bisphenol A/epichtorhydrin condensates, bisphenol F/epichlorhydrin condensates, and polymers and copolymers of glycidyl acrylate and methacrylate.

The dielectric layer may be deposited by known means including but not limited to inkjet printing, screen printing, spin coating, gravure, flexographic or lithographic printing.

In a preferred embodiment, the patterning material is adapted to attach to surface hydroxyl groups.

Advantageously, the patterning material is adapted to bind a material which is catalytic to electroless deposition of metal. For example, the patterning material may comprise at least one of a phosphonic acid material, a trihalosilane material and a trialkoxy silane material substituted with one or more amines, aminocarboxy thiol, diketonate, oxime or substituted phosphine groups.

Conveniently, the step of applying the conductive material to the support layer comprises etectroless deposition from a solution comprising at least one transition metal compound (e.g. gold, silver, copper, nickel, palladium, platinum etc).

Preferably, the step of applying the patterning material comprises soft lithographic step, more preferably a microcontact printing step.

According to the microcontact printing method, a conformable stamp is made which carries a relief pattern representing the image to be printed. Such stamp may be fabricated for example by fabrication of a relief master pattern in photoresist, silicon or metal according to known methods. A curable prepolymer such as Dow Corning Sylgard 184 is placed in liquid form onto the master pattern and cured. The polymer is peeled away to provide an elastomeric conformable stamp which replicates the master pattern in negative relief. Other curable polymers may be used including curable methyl phenyl siloxanes, polyurethanes, polyether-acrylates, and polyacrylics. Thermal or photochemical curing may be employed. The stamp is treated with material to be printed down as a neat liquid or in solution, and any excess material is removed from the surface. The treated stamp is placed in contact with the surface on which the pattern is to be printed, and left under light pressure. After a short time the stamp is removed by lifting or peeling it away from the substrate. The substrate now carries a thin, possibly monomolecular, patterned deposit of the desired material. The stamp may be reused many times.

According to another aspect of the present invention, there is now proposed a method of applying electrodes to an organic thin film transistor comprising the steps of:
(i) providing a substantially conductive gate electrode,
(ii) depositing an epoxide polymer on at least part of the gate electrode so as to form a gate insulator layer,
(iii) printing a patterning material only to selected areas of the gate insulator layer, the patterning material being adapted to adhere thereto and to modulate the surface energy thereof in the regions thereto applied,
(iv) applying to the gate insulator layer a catalyst responsive to the patterning material,
(v) depositing a metallic material on the gate insulator layer by electroless deposition so as to form source and drain electrodes only on the selected areas of the gate insulator layer to which the catalyst material has been applied.

The substantially conductive gate electrode may be pre-formed. Alternatively, the step of providing the substantially conductive gate electrode may include, without limitation, depositing the substantially conductive gate electrode, for example onto a substrate.

The catalyst may be adapted to respond to the patterning material by preferentially attaching to thereto (i.e. the catalyst has a high chemical affinity for the patterning material). Alternatively, the catalyst may be adapted to respond to the patterning material by preferentially detaching there-from (i.e. the catalyst has a low chemical affinity for the patterning material).

The method may conveniently include the further step of;
(vi) providing a semiconductor layer on at least part of the gate insulator layer so as to sandwich the source and drain electrodes there-between and to bridge said source and drain electrodes.

According to one example of the invention, there is now provided a thin film transistor having a gate insulator layer comprising an epoxide material characterised by plated metallic source and drain electrodes disposed on the gate insulator layer.

Epoxide based materials have been found to possess an excellent combination of physical, chemical and electronic properties when used as the dielectric material in an organic FET. These advantageous properties include high electrical resistance over a broad frequency range, environmental stability, ease of processing, low toxicity, low tendency to absorb or bind ionic impurities, resistance to the solvents and process chemicals used in device fabrication, mechanical ruggedness, and a low tendency to polarisation effects and field bias artefacts when the device is operated. In contrast to dielectric materials proposed in the prior art for use in fabrication, epoxy materials provide a dielectric material which is highly compatible with both soft lithography and electroless metal growth. In particular the epoxide dielectric materials do not bind electroless catalysts to their surface, have suitable surface energy and surface hydroxyl groups to bind a range of patterning materials, and have excellent resistance to electroless plating solutions comprising strong solutions of metal ions, complexing agents and reducing agents in strongly acidic or basic media.

In another example, the epoxide material comprises an epoxide compound having a degree of functionality in the range 1 -12. The degree of functionality of the compound relates to the number of reactive groups in each molecule as will be readily understood by the skilled practitioner. The epoxide material may comprise at least one of SU8 epoxy resin, alkyl and cycloalkyl glycidyl ethers having an alkyl chain length from 1 to 20, aryl glycidyl ethers, ethylene glycol bis glycidyl ether, propylene glycol bis glycidyl ether, trimethylolpropane triglycidyl ether, esters of glycidol, bisphenol A/epichtorhydrin condensates, bisphenol F/epichlorhydrin condensates, and polymers and copolymers of glycidyl acrylate and methacrylate.

Plated electrodes confer benefit to the devices by providing electrodes which are fabricated with high resolution patterning, at low temperature, for example below 100°C, without requiring vacuum processing, without need for photolithographic processing of the substrate, and at low cost.

In the interests of clarity, plated electrodes refers specifically, but not exclusively, to electrodes formed by an electroless or electrolytic processes. For example, such plated electrodes may be formed by depositing metal using an electroless plating solution.

Preferably, the plated metallic source and drain electrodes comprise a transition metal, preferably one of gold, silver, copper, nickel, palladium and platinum.

The thin film transistor may have interdigitated source and drain electrodes.

According to another example of the present invention, there is now proposed an electronic integrated circuit having a plurality of thin film transistor devices according to the foregoing aspect of the invention.

According to a further example of the invention, there is now proposed a display device having an electronic integrated circuit as described above.

The invention will now be described, by example only, with reference to the accompanying drawings in which;

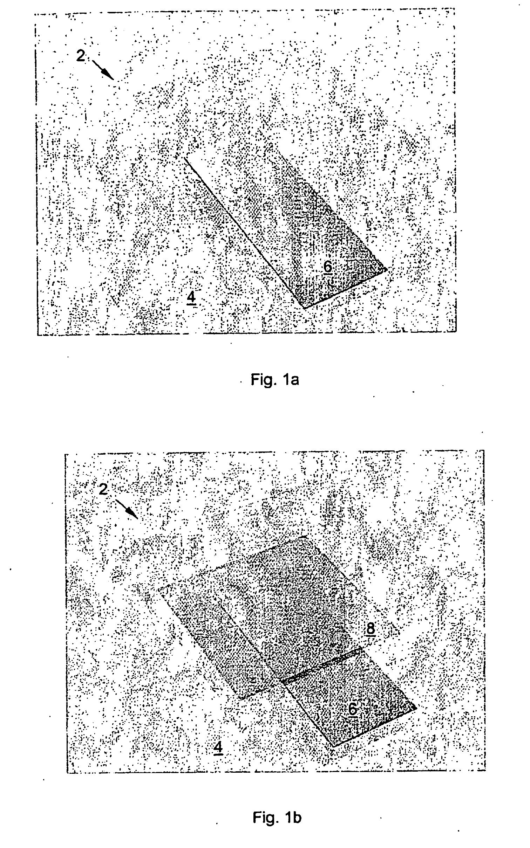

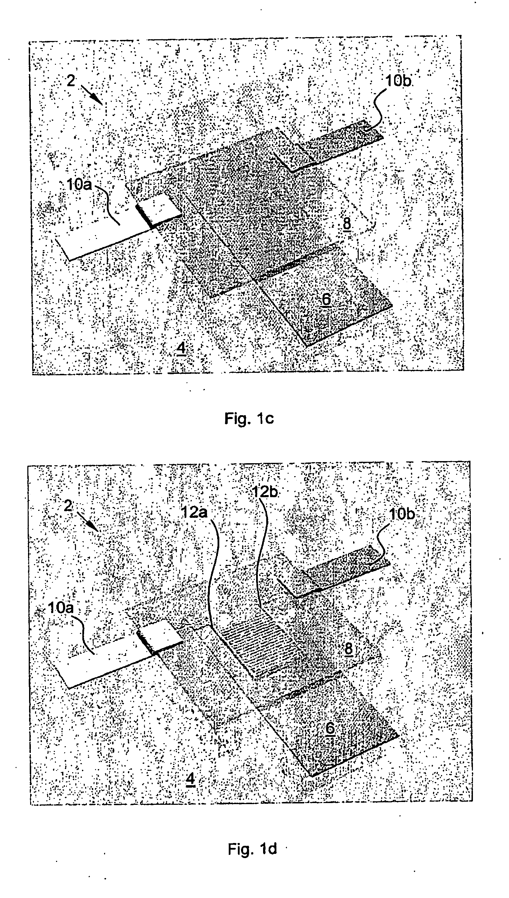

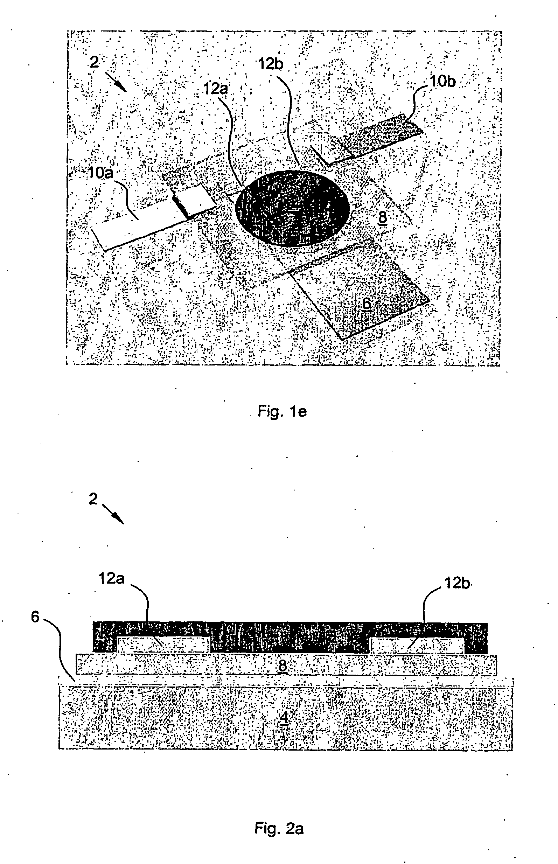

Figures 1a - 1e show the sequential steps according to one embodiment of the present method of fabricating a semiconductor device. The semiconductor device in this particular embodiment comprises a thin-film transistor. Specifically, figure 1a shows the step of forming of a gate electrode; figure 1b illustrates the step of depositing a gate dielectric layer; figure 1c shows the formation of source and drain contacts; figure 1d illustrates the step of depositing source and drain electrodes onto the gate dielectric layer; and figure 1e shows the step of applying a semiconductor layer to the thin film transistor.

Figure 2a shows a schematic cross sectional representation of a thin film transistor according to one embodiment of the invention; Figure 2b illustrates a schematic cross sectional representation of an inverted thin film transistor structure according to an alternative embodiment of the invention.

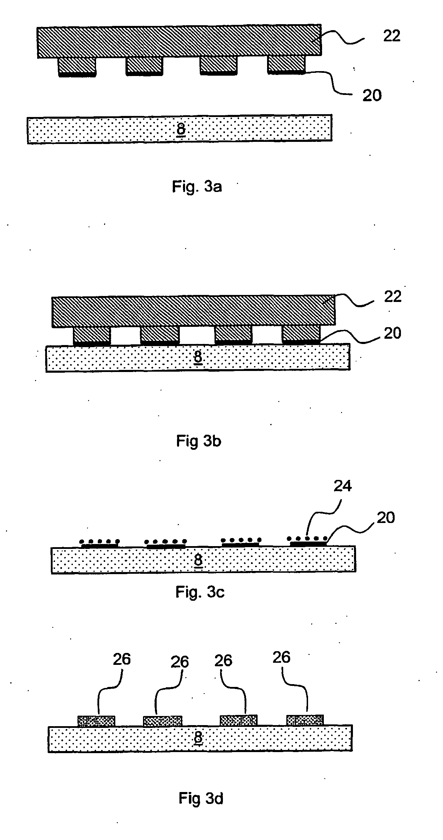

Figures 3a - 3d illustrate the sequential steps according to one embodiment of the present method for printing a patterning material onto the gate dielectric of the thin film transistor shown in figure 2a. Specifically, figure 3a shows an elastomeric stamp 22 carrying the patterning material 20, ready to be applied to the dielectric layer; figure 3b illustrates the step of transferring the patterning material 20 from the stamp 22 to the dielectric layer 8; figure 3c shows the step of applying a catalyst 24 which attaches selectively to the areas of the dielectric layer 8 to which the patterning material 20 has been applied; and figure 3d illustrates the step of applying an electroless plating solution so as to deposit metal 26 preferentially on the areas of the dielectric layer 8 to which the catalyst 24 has been applied.

Figure 4 shows a graph of source-drain current (I_{sd}) versus source-drain voltage (V_{sd}) for a printed thin film transistor according to one embodiment of the present invention fabricated using the present method.

Figure 5 shows a graph of source-drain current (I_{sd}) or source-gate current (I_{sg}) versus gate voltage (V_{g}) for a printed thin film transistor according to one embodiment of the present invention fabricated using the present method.

Figure 6 shows a graph of source-drain current (I_{sd}) versus gate voltage (V_{gate}) for an inverted printed thin-film transistor of figure 2b fabricated using one embodiment of the present method.

Referring now to the drawings wherein like reference numerals identify corresponding or similar elements throughout the several views, figures 1a - 1e show the sequential steps according to a first embodiment of the present method of fabricating a semiconductor device. The semiconductor device in this particular embodiment comprises a thin-film transistor 2.

Referring to figure 1a, a substrate 4 is first provided with a conductive layer 6 which will form the gate electrode of the thin film transistor device. In this embodiment a single thin film transistor is to be fabricated, however it will be clear to the person skilled in the art that the conductive layer may be patterned to allow the independent switching of a plurality of thin film transistor devices manufactured on a common substrate.

Optionally the conductive pattern is extended to provide part or all of an interconnect from one thin film transistor to another, to a passive component, semiconductor component or to a connection terminal.

The conductive layer 6 is deposited by printing alternatively by plotter pen. These printing techniques are particularly suited to the deposition of conductive poly(aniline) or PEDOT. Alternatively, where the conductive layer 6 is to be fabricated from a metal or carbon loaded ink, the layer 6 is deposited by screen, lithographic, flexographic or gravure printing. Where the conductive layer 6 is fabricated from a metal colloid ink, deposition may be followed by an anneal process which serves to raise the conductivity of the deposited layer. Such anneal process may be carried out for example by heat or laser treatment. Optionally, the deposition process is followed by selective etching.

The conductive layer 6 may comprise any conductive material including but not limited to metals, doped semiconductors, conducting polymers, indium tin oxide and carbon.

In one embodiment, a catalyst or chemical reagent is coated onto the surface of the substrate 4 and used to initiate deposition of metal by electroless or electrolytic processes to form the conductive layer 6. Optionally, the catalyst or reagent is patterned by conventional means or by soft lithography.

Referring now to figure 1b, a dielectric material is now coated onto the substrate to form a dielectric layer 8. The coating of dielectric material may be continuous or patterned. As shown in figure 1b, the dielectric layer 8 substantially covers at least the parts of the conductive layer 6 which will be used as the thin film transistor gate electrode or electrodes in the case of a substrate having several thin film transistor devices thereon.

The dielectric layer 8 does not completely cover parts of the conductive layer 6 which will be used to provide part interconnects and connection terminals.

The dielectric layer 8 is deposited by any of a plurality of known means including but not limited to inkjet printing, screen printing, spin coating, gravure, flexographic or lithographic printing.

The dielectric layer 8 comprises an organic epoxide (oxirane) compound with a degree of functionality in the range 1-12. For example, the dielectric material may comprise at least one of SU8 epoxy resin, alkyl and cycloalkyl glycidyl ethers having an alkyl chain length from 1 to 20, aryl glycidyl ethers, ethylene glycol bis glycidyl ether, propylene glycol bis glycidyl ether, trimethylolpropane triglycidyl ether, esters of glycidol, bisphenol A/epichlorhydrin condensates, bisphenol F/epichtorhydrin condensates, and polymers and copolymers of glycidyl acrylate and methacrylate.

In one embodiment, the dielectric material comprises an epoxide monomer or copolymer. In this case the dielectric layer includes a reagent which crosslinks or polymerises the epoxide units, for example triphenylsulphonium salts, boron trifluoride-amine adducts, polyfunctional amines, carboxylic acid anhydrides and polyfunctional thiols.

The dielectric layer 8 is cured after coating onto the conductive layer 6. In the case of photosensitive curing agents such as triarylsulphium salts, the insulating coating is optionally selectively cured by exposure through a mask or by using a scanned light source, and uncured material removed.

Referring to figures 1c and 1d, a patterning material is now printed onto the dielectric layer 8. The patterning material is printed at least onto those areas of the dielectric layer 8 on which source and drain electrodes 12a, 12b are intended to be formed to provide a thin film transistor structure. Optionally the patterning material is extended onto areas of the dielectric layer 8 and / or the substrate 4 in order to form part or complete interconnects and or connection terminals 10a, 10b. Alternatively, interconnects or connection terminals 10a, 10b are deposited by printing before or after the treatment with the patterning material.

The patterning material is characterised by the presence of at least two chemical functionalities. At least one chemical functionality is capable of chemical linking to surface hydroxy groups in the dielectric layer 8. At least one chemical functionality is capable of binding a material which is catalytic to electroless deposition of metal. Preferred patterning materials include substantive inks comprising a phosphonic acid material, trialkoxy silanes substituted with amine, aminocarboxy, thiol, diketone, oxime or substituted phosphine groups. The patterning material is printed with high resolution; soft lithography is particularly preferred for this step.

The device 2 is now treated successively with a catalyst and with an electroless plating solution. Suitable catalysts include colloidal noble metals such as palladium, gold and silver, combinations of colloidal metals with salts such as tin(II) chloride, and salts of selected metals such as silver and palladium. The electroless metal plating solution may be a solution of the known art such as those described in "Electroless Plating: Fundamentals and Applications" by G Mallory and J B Hadju, published by the American Electroplaters and Surface Finishers Society.

By this process a conductive metal pattern is deposited on the surface of the dielectric layer 8 in a pattern defined .by the pattern of the patterning material previously deposited. At least part of said pattern is so arranged as to provide metallic source and drain electrodes 12a, 12b with a small gap there-between for the thin film transistor structure. The source and drain electrodes are electrically isolated from the conductive gate electrode 6 (except as may be desired to achieve a defined electronic function) by the dielectric layer 8.

Referring now to figure 1e, a semiconductor material is now deposited so as to form a substantially continuous semiconductor layer 14 bridging at least part of the pair of source electrode and drain electrodes 12a, 12b. Known semiconductors which may be used include sputtered cadmium selenide, amorphous silicon, and polycrystalline silicon.

Typical materials comprise solution processable semiconductors including poly(alkylthiophene), poly(phenylenevinylenes), soluble pentacene precursors, semiconducting perovskites, chemical bath deposited cadmium sulphide, cadmium selenide, or lead sulphide, and dispersions of semiconducting nanorods and nanoribbons of silicon or cadmium selenide, chalcogenides and carbon nanotubes having nanometric scale in at least one dimension perpendicular to the long axis of the rod or tube.

Referring to figure 2a, a schematic cross sectional representation of a thin film transistor according to one embodiment of the invention is shown having metallic source and drain electrodes 12a, 12b arranged between an upper semiconductor layer 14 and an underlying conductive gate electrode layer 6. In this particular embodiment, the source and drain electrodes comprise electroless metal. The conductive gate electrode 6 comprises an indium tin oxide (ITO) layer and the dielectric layer 8 comprises a 550nm thick layer of SU8 polymer. The device is constructed on a glass substrate 4.

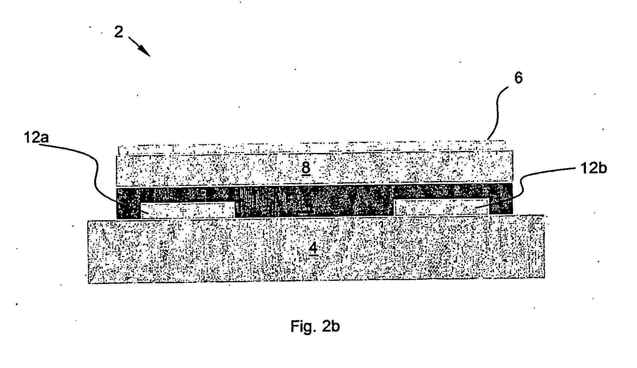

Figure 2b illustrates a schematic cross sectional representation of an inverted thin film transistor structure according to an alternative embodiment of the invention. In this embodiment, the substrate 4 may comprise an organic epoxide (oxirane) compound with a degree of functionality in the range 1-12. Alternatively, the substrate 4 may have a layer of organic epoxide (oxirane) material applied thereon. For example, the substrate or the layer applied thereto may comprise at least one of SU8 epoxy resin, alkyl and cycloalkyl glycidyl ethers having an alkyl chain length from 1 to 20, aryl glycidyl ethers, ethylene glycol bis glycidyl ether, propylene glycol bis glycidyl ether, trimethylolpropane triglycidyl ether, esters of glycidol, bisphenol A/epichlorhydrin condensates, bisphenol F/epichlorhydrin condensates, and polymers and copolymers of glycidyl acrylate and methacrylate.

Referring to figure 3, the sequence of steps in the present method for printing a patterning material onto the gate dielectric layer 8 comprises: applying the patterning material 20 to an elastomeric stamp 22 (figure 3a); transferring the patterning material 20 from the stamp 22 to the dielectric layer 8 (figure 3b); applying a catalyst 24 which attaches selectively to the areas of the dielectric layer 8 to which the patterning material 20 has been applied (figure 3c); and applying an electroless plating solution so as to deposit metal 26 preferentially on the areas of the dielectric layer 8 to which the catalyst 24 has been applied.

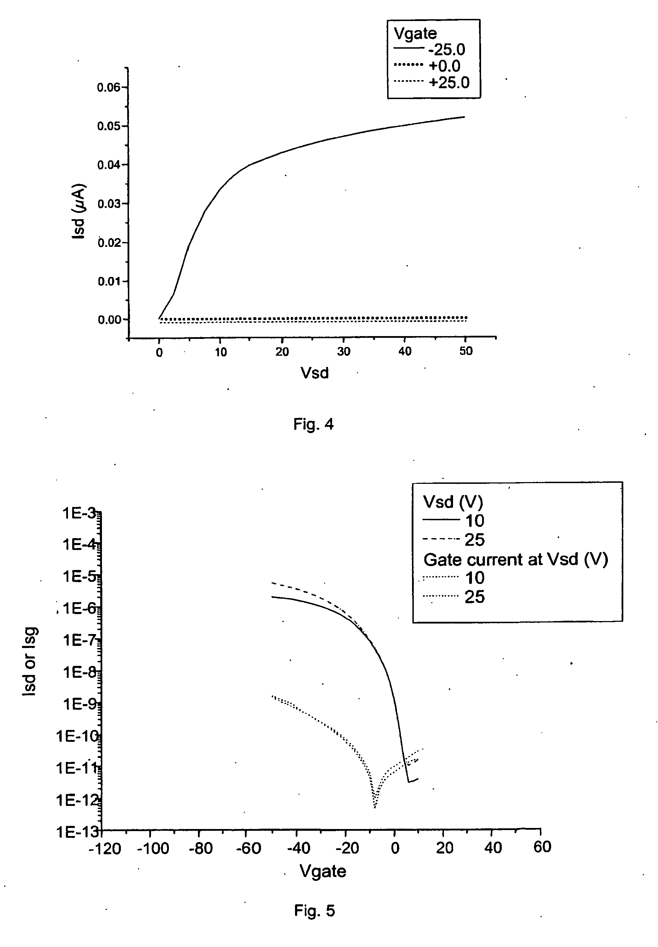

Figure 4 shows a graph of source-drain current (I_{sd}) versus source-drain voltage (V_{sd}) for a printed thin film transistor according to one embodiment of the present invention fabricated using the present method.

Figure 5 shows a graph of source-drain current (I_{sd}) or source-gate current (I_{sg}) versus gate voltage (V_{gate}) for a printed thin film transistor according to one embodiment of the present invention fabricated using the present method.

The printed TFT fabricated according to this invention has excellent properties when compared to other printed, organic channel TFTs described in the prior art, including a field effect mobility above 0.1cm²V⁻¹s⁻¹, a current switching ratio Ion/Ioff of 10⁷, and a turn-on voltage of +5.5V

By way of a specific example of one embodiment of the present invention, a method of fabricating an inverted thin-film transistor of figure 2b comprises the following steps; a glass support substrate is coated with a 200nm thick layer of the commercially available epoxide derivative SU8, exposed to UV light and then baked to effect curing. The epoxide layer is washed with acetone and isopropyl alcohol and dried, following which the surface is exposed to a UV/ozone treatment for 5 minutes. The surface is then imprinted with a patterning material by micro-contact printing from a silicone rubber stamp carrying a relief pattern of interdigitated fingers, each 5*µ*m wide, spaced 5*µ*m apart, and 200*µ*m long, arranged to define interdigitated source and drain electrodes of the thin film transistor after processing.

Following the microcontact printing step, the substrate is baked at 100C for 1 minute and immersed sequentially in a palladium/tin catalyst bath at 40C for 1 minute, 1M hydrochloric acid solution at 20C for 1 minute, and three wash tanks of deionised water for 1 minute each. The substrate is next immersed in an electroless metal plating bath at 40C. After the initiation of metal growth, it is allowed to continue for 10 seconds, then washed in deionised water for 1 minute, dried at 150C, cooled to room temperature and washed in 1 M hydrochloric acid for 5 minutes. The substrate is washed with deionised water, dried at 100C and again exposed to UV/ozone treatment for 5 minutes, and then to an atmosphere saturated with vapour of hexamethyldisilazane for 18 hours at room temperature. The device is removed from the vapour bath, baked at 100C for 10 minutes, and an organic semiconductor based on regioregular poly(3-hexylthiophene) is deposited by spin coating (0.1% solution in dichlorobenzene, coated at 200rpm for 30 seconds followed by 1000rpm for 10 seconds). The device is dried to remove solvent at 100C for 30 seconds. A dielectric polymer is spin coated onto the device (3000rpm for 30 seconds) and cured by heating at 135C for 3 hours. The resulting dielectric surface is treated by UV/ozone for 2 minutes, then a silver colloid ink (Cabot corporation) is printed onto the device overlying the interdigitated electrodes by inkjet, and cured at 100C for 10 minutes.

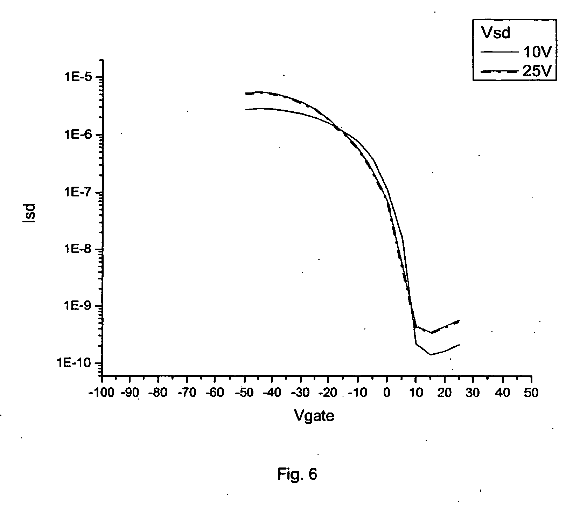

Figure 6 shows a graph of source-drain current (I_{sd}) versus gate voltage (V_{gate}) for a inverted thin-film transistor fabricated according to the foregoing method.

## Claims

1. A method of fabricating an electrode structure for a multilayer semiconductor device comprising a semiconductor layer (14) having a first electrode layer in contact therewith and a second electrode layer separated there-from by a dielectric layer (8), the method comprising the steps of;
(i) applying a patterning material (20) only to selected areas of a support layer so as to define the arrangement of the first electrode layer thereon,
(ii) applying to the support layer a catalyst (24) adapted to be responsive to the patterning material (20),
(iii) applying a conductive material (26) to the support layer so as to form the first electrode layer thereon, the step of applying the conductive material to the support layer comprising electroless deposition,
wherein the support layer, the patterning material (20) and the catalyst (24) cooperate such that the conductive material (26) is only deposited on the selected areas of the support layer to which the catalyst (24) has been applied,
**characterised in that** the support layer comprises an epoxide compound.

2. A method according to claim 1 wherein the support layer comprises the dielectric layer (8).

3. A method according to claim 2 comprising an initial step of forming the second electrode layer and applying a dielectric material thereto so as to form the dielectric layer (8) thereon.

4. A method according to claim 3 wherein the conductive material (26) is deposited on the dielectric layer (8) so as to form a first and a second metallic electrode (12a, 12b) thereon, and further comprising the step of;
(iv) forming the semiconductor layer (14) by applying a semiconductor material to at least part of the dielectric layer (8) so as to make electrical contact with the first and second metallic electrodes (12a, 12b).

5. A method according to claim 1 wherein the support layer comprises a substrate layer (4).

6. A method according to claim 5 wherein the conductive material 26 is deposited on the substrate layer (4) so as to form a first and a second metallic electrode (12a, 12b) thereon, and further comprising the steps of;
(iv) forming the semiconductor layer (14) by applying a semiconductor material to at least part of the substrate layer (4) so as to make electrical contact with the first and second metallic electrodes (12a, 12b),
(v) applying a dielectric material to the semiconductor layer (14) so as to form the dielectric layer (8) thereon,
(vi) forming the second electrode layer by applying a substantially conductive electrode (6) to the dielectric layer (8).

7. A method according to any of the preceding claims wherein the semiconductor device is configured as a thin film transistor (2) in which the second electrode layer forms a substantially conductive gate electrode (6) and the first and second metallic electrodes (12a, 12b) form the source and drain respectively.

8. A method according to any of claims 3, 4, or 6, or claim 7 when dependent on any of claims 3, 4, or 6 wherein the dielectric material comprises an epoxide compound having a degree of functionality in the range 1 - 12, wherein the degree of functionality of the compound relates to the number of reactive groups in each molecule.

9. A method according to any of the preceding claims wherein the patterning material (20) is adapted to attach to surface hydroxyl groups.

10. A method according to any of the preceding claims wherein the patterning material (20) is adapted to bind a material which is catalytic to electroless deposition of metal.

11. A method according to any of the preceding claims wherein the patterning material (20) comprises at least one of a phosphinic acid material, a trihalosilane material and a trialkoxy silane material substituted with one or more amine, aminocarboxy thiol, diketonate, oxime or substituted phosphine groups.

## Patentansprüche

1. Verfahren zur Herstellung einer Elektrodenstruktur für ein Multilayer-Halbleiterbauelement, das eine Halbleiterschicht (14) umfasst, die eine mit ihr in Kontakt stehende erste Elektrodenschicht und eine durch eine dielektrische Schicht (8) von ihr getrennte zweite Elektrodenschicht aufweist, wobei das Verfahren die folgenden Schritte umfasst:
(i) Aufbringen eines strukturierenden Materials (20) lediglich auf ausgewählte Bereiche einer Trägerschicht, um die Anordnung der ersten Elektrodenschicht darauf festzulegen,
(ii) Aufbringen eines Katalysators (24), der geeignet ist, auf das strukturierenden Material (20) zu reagieren, auf die Trägerschicht,
(iii) Aufbringen eines leitfähigen Materials (26) auf die Trägerschicht, um darauf die erste Elektrodenschicht auszubilden, wobei der Schritt, in dem das leitfähige Material auf die Trägerschicht aufgebracht wird, eine stromlose Abscheidung umfasst,
wobei die Trägerschicht, das strukturierende Material (20) und der Katalysator (24) so zusammenwirken, dass das leitfähige Material (26) nur auf den ausgewählten Bereichen der Trägerschicht, auf die der Katalysator aufgebracht wurde, abgeschieden wird,
**dadurch gekennzeichnet, dass** die Trägerschicht ein Epoxid umfasst.

2. Verfahren nach Anspruch 1, worin die Trägerschicht die dielektrische Schicht (8) umfasst.

3. Verfahren nach Anspruch 2, das einen anfänglichen Schritt zum Ausbilden der zweiten Elektrodenschicht und ein Aufbringen eines dielektrischen Materials darauf umfasst, um die dielektrische Schicht (8) auf ihr auszubilden.

4. Verfahren nach Aspruch 3, worin das leitfähige Material (26) auf der dielektrischen Schicht (8) zur Ausbildung einer ersten und einer zweiten Metallelektrode (12a, 12b) darauf abgeschieden wird, und das ferner den folgenden Schritt umfasst:
(iv) Ausbilden der Halbleiterschicht (14) durch Aufbringen eines Halbleitermaterials auf zumindest einen Teil der dielektrischen Schicht (8), um den elektrischen Kontakt mit der ersten und zweiten Metallelektrode (12a, 12b) herzustellen.

5. Verfahren nach Anspruch. 1, worin die Trägerschicht eine Substratschicht (4) umfasst.

6. Verfahren nach Anspruch 5, worin das leitfähige Material (26) auf der Substratschicht (4) abgeschieden wird, um darauf eine erste und zweite Metallelektrode (12a, 12b) auszubilden, und das ferner Schritte aufweist zum:
(iv) Ausbilden der Halbleiterschicht (14) durch Aufbringen eines Halbleitermaterials auf zumindest einen Teil der Substratschicht (4), um den elektrischen Kontakt mit der ersten und zweiten Metallelektrode (12a, 12b) herzustellen,
(v) Aufbringen eines dielektrischen Materials auf die Halbleiterschicht (14), um die dielektrische Schicht (8) darauf auszubilden,
(vi) Ausbilden der zweiten Elektrodenschicht durch Aufbringen einer im Wesentlichen leitfähige Elektrode (6) auf die dielektrische Schicht (8).

7. Verfahren nach einem der vorhergehenden Ansprüche, worin das Halbleiterbauelement als Dünnschichttransistor (2) ausgeführt ist, bei dem die zweite Elektrodenschicht eine im Wesentlichen leitfähige Gate-Elektrode (6) bildet und die erste und zweite Metallelektrode (12a, 12b) Source bzw. Drain bilden.

8. Verfahren nach einem der Ansprüche 3, 4 oder 6 oder nach Anspruch 7, soweit abhängig von einem der Ansprüche 3, 4 oder 6, wobei das dielektrische Material ein Epoxid umfasst, das einen Funktionalitätsgrad im Bereich von 1 bis 12 aufweist, wobei sich der Funktionalitätsgrad der Verbindung auf die Anzahl der rcaktiven Gruppen in jedem Molekül bezieht.

9. Verfahren nach einem der vorhergehenden Ansprüche, worin das strukturierende Material (20) befähigt ist, an Oberflächen-Hydroxygruppen zu binden.

10. Verfahren nach einem der vorhergehenden Ansprüche, worin das strukturierende Material (20) befähigt ist, eine Bindung mit einem Material einzugehen, das für die stromlose Metallabscheidung katalytisch wirkt.

11. Verfahren nach einem der vorhergehenden Ansprüche, worin das strukturierende Material (20) zumindest eines von Folgenden umfasst: ein Phosphinsäurematerial, ein Trihalogensilanmaterial, ein Trialkoxysilanmaterial, das substituiert ist mit einer oder mehreren Amin-, Aminocarboxy-, Triol-, Diketonat-, Oxim- oder substituieren Phosphingruppen.

## Revendications

1. Procédé de fabrication d'une structure d'électrode pour un dispositif semi-conducteur multicoucbe comprenant une couche semi-conductrice (14) ayant une première couche d'électrode en contact avec celle-ci et une seconde couche d'électrode séparée de celle-ci par une couche diélectrique (8), le procédé comprenant les étapes suivantes :
(i) l'application d'un matériau de formation de motifs (20) uniquement sur les zones sélectionnées d'une couche de support afin de définir l'agencement de la première électrode sur celle-ci,
(ii) l'application sur la couche de support d'un catalyseur (24) conçu pour être réceptif au matériau de formation de motifs (20),
(iii) l'application d'un matériau conducteur (26) sur la couche de support afin d'y former la première couche d'électrode, l'étape d'application du matériau conducteur sur la couche de support comprenant un dépôt autocatalytique,
dans lequel la couche de support, le matériau de formation de motifs (20) et le catalyseur (24) coopèrent de telle sorte que le matériau conducteur (26) est uniquement déposé sur les zones sélectionnées de la couche de support sur lesquelles le catalyseur (24) a été appliqué,
**caractérisé en ce que** la couche de support comprend un composé époxyde.

2. Procédé selon la revendication 1, dans lequel la couche de support comprend la couche diélectrique (8).

3. Procédé selon la revendication 2 comprenant une étape initiale de formation de la seconde couche d'électrode et d'application d'un matériau diélectrique sur celle-ci afin d'y former la couche diélectrique (8).

4. Procédé selon la revendication 3, dans lequel le matériau conducteur (26) est déposé sur la couche diélectrique (8) afin d'y former une première et une seconde électrodes métalliques (12a, 12b) et comprenant en outre l'étape suivante :
(iv) la formation de la couche semi-conductrice (14) par application d'un matériau semi-conducteur sur au moins une partie de la couche diélectrique (8) afin d'établir un contact électrique avec les première et seconde électrodes métalliques (12a, 12b).

5. Procédé selon la revendication 1, dans lequel la couche de support comprend une couche de substrat (4).

6. Procédé selon la revendication 5, dans lequel le matériau conducteur (26) est déposé sur la couche de substrat (4) de sorte à y former une première et seconde électrodes métalliques (12a, 12b), et comprenant en outre les étapes suivantes :
(iv) la formation de la couche semi-conductrice (14) par application d'un matériau semi-conducteur sur au moins une partie de la couche de substrat (4) afin d'établir un contact électrique avec les première et seconde électrodes métalliques (12a, 12b),
(v) l'application d'un matériau diélectrique sur la couche semi-conductrice (14) afin d'y former la couche diélectrique (8),
(vi) la formation de la seconde couche d'électrode par application d'une électrode sensiblement conductrice (6) sur la couche diélectrique (8).

7. Procède selon l'une quelconque des revendications précédentes, dans lequel le dispositif semi-conducteur est configuré sous forme d'un transistor à couches minces (2) dans lequel la seconde couche d'électrode forme une électrode de grille sensiblement conductrice (6) et les première et seconde électrodes métalliques (12a, 12h) forment respectivement la source et le drain.

8. Procédé selon l'une quelconque des revendications 3, 4. ou 6, ou la revendication 7 lorsqu'elle dépend de l'une des revendications 3, 4 ou 6, dans lequel le matériau diélectrique comprend un composé époxyde ayant un degré de fonctionnalité dans la plage de 1 à 12, le degré de fonctionnalité du composé étant relatif au nombre de groupes réactifs dans chaque molécule.

9. Procède selon l'une quelconque des revendications précédentes, dans lequel le matériau de formation de motifs (20) est conçu pour se fixer aux groupes hydroxyles superficiels,

10. Procédé selon l'une quelconque des revendications précédentes, dans lequel le matériau de formation de motifs (20) est conçu pour lier un matériau qui est catalytique à un dépôt de metal autocatalytique.

11. Procédé selon l'une quelconque des revendications précédentes, dans lequel le matériau de formation de motifs (20) comprend au moins l'un d'un matériau d'acide phosphinique, d'un matériau de trihalosilane et d'un matériau de trialcoxy silane substitué par un ou plusieurs groupes amine, arninocarboxy thiol, dicétonate, oxime ou phosphine substituée.
